# EUROPEAN PATENT APPLICATION

(11) **EP 2 325 350 A1**
(43) Date of publication of application: **25.05.2011**
(21) Application number: 09176921.6
(22) Date of filing: 24.11.2009
(51) Int. Cl.: C23C 14/35, H01J 37/32, H01J 37/34

(54) **Anode rod for a sputtering system**

(71) Applicant: Applied Materials, Inc., Santa Clara, CA 95054 (US)
(72) Inventor: Buschbeck, Wolfgang, 63454, Hanau (DE); Bender, Marcus, 63454, Hanau (DE); Lindenberg, Ralph, 63654, Buedingen - Rinderbuegen (DE); Klein, Wolfgang, 63939, Woerth (DE); Berger, Thomas, 55585, Norheim (DE)
(74) Representative: Zimmermann, Gerd Heinrich

(57) **Abstract**

The present disclosure relates to an anode rod (140a, 140b, 140c, 240, 340, 440, 540, 640, 740, 840) for a sputtering system comprising a target (126a, 126b), a lateral surface area of the anode rod is at least 2 times greater than the lateral surface area of a circular cylinder having the same volume. Further, the present disclosure relates to a sputtering system (100) comprising at least one anode rod according the invention and at least one sputtering cathode assembly (120a, 120b, 820) comprising a backing plate for a planar target or a target backing tube (122a, 122b) for a rotatable cylindrical target.

## Description

The present disclosure relates to an anode rod for a sputtering system, in particular for a sputtering system comprising a rotatable target. According to a further aspect, the present disclosure relates to a sputtering system comprising at least one anode rod.

### BACKGROUND

In many applications, it is necessary to deposit thin layers on a substrate. The term "substrate" as used herein shall embrace both inflexible substrates, e.g., a wafer or a glass plate, and flexible substrates such as webs and foils. Typical techniques for depositing layers are evaporating, sputtering and chemical vapor deposition.

Representative examples include (but are not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-electro-mechanical systems (NEMS), micro-optic and optoelectronic devices, transparent substrates, architectural and automotive glasses, metallization systems for metal and polymer foils and packaging, and micro- and nano-molding.

In an evaporation process, the material to be deposited is heated so that it evaporates and condenses on the substrate. Sputtering is a vacuum coating process used to deposit thin films of various materials onto the surface of a substrate. For example, sputtering can be used to deposit a metal layer, such as a thin layer of aluminum, or ceramics. During the sputtering process, the coating material is transported from a target to the substrate to be coated by bombarding the surface of the target with ions of an inert gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of the substrate's exposure to the sputtering process. Typically, sputtering systems are used to coat substrates, for example window paints, semiconductor devices, displays, and the like. Typically plasma is formed in a vacuum chamber, in which the sputtering target is disposed. For example, rotating sputtering targets may be used. Typically, the rotating sputtering targets have a cylindrical form and rotate about their longitudinal axis. The sputtering targets are disposed on a backing tube in which magnetrons may be arranged. The magnetrons may be driven by a direct current or an alternating current. The magnetrons are used to create the plasma in the vacuum chamber. Typically, also anode rods are disposed in the vacuum chamber to collect and transport electrons out of the vacuum chamber.

Typically, during operation, the targets and the backing tubes get very hot. The magnetic properties of the magnetrons may deteriorate due to high temperatures. Thus, the magnetrons in the target backing tube are typically cooled. Further, in the vacuum chamber, very high temperatures of the anode rod are created during the physical vapor deposition, in particular as a function of the applied power. In the vacuum chamber, during operation of the sputtering system, the anode rods are heated by the plasma current to temperatures of about 300 to 500 °C. Under high thermal load, the temperature of the anodes may cause problems, for example a high thermal expansion or even damage the anode rods.

### SUMMARY

In light of the above, an anode rod for a sputtering system according to independent claim 1 and a sputtering system according to independent claim 13 are provided.

According to an embodiment, an anode rod for a sputtering system is provided comprising a target, the lateral surface area of the anode rod is at least 2 times greater than the lateral surface area of the a circular cylinder having the same volume.

According to an embodiment, the emissive power of the anode rod is at least 1,5 times greater, in particular at least two times greater, than the emissive power of a circular cylinder having the same volume and having an emissivity of ε=0,2.

According to an embodiment, for example, the lateral surface area of the anode rod is at least 3, 4, 5, and/or 6 times greater than the lateral surface area of the a circular cylinder having the same volume.

In a typical embodiment, which may be combined with other embodiments disclosed herein, the anode rod has a basic body, wherein the basic body has a lateral area and a cross section, the cross section is selected of the group consisting of: a circle, of a semi-circle, of an oval, a semi-oval, a square, and a rectangle.

In an embodiment, the anode rod has at least one recess, in particular at least two, three, four, five or more recesses, formed in a lateral area of the basic body, wherein the recesses are formed in particular as a groove and/or has at least one protrusion, in particular at least two, three, four, five or more protrusions, formed on a lateral area of the basic body, wherein the protrusions are formed in particular as a rib and/or as a nose.

In a typical embodiment, the at least one groove and/or the at least one rib has or have a longitudinal length of at least 50%, in particular at least 70%, of the axial extension of the anode rod.

Typically, the at least one rib and/or groove has or have a longitudinal extension parallel to the axial direction of the anode rod.

For example, in an embodiment, the at least one rib and/or the at least one groove has or have a cross section selected from the group consisting of a substantial triangular cross-section, trapezoidal cross-section, rectangular cross-section, semi-circular cross-section, and any combinations thereof.

In an embodiment, which may be combined with other embodiments disclosed herein, the at least one protrusion and/or the at least one recess is or are disposed in a regular angular displacement around the circumference of the basic body.

Typically, in an embodiment, the at least one protrusion and/or at least one recess is or are disposed, in particular regularly spaced apart, on a contiguous portion of the lateral area of the basic body, the contiguous portion is more than about 25 percent, in particular more than 40 percent, of the lateral area of the basic body.

In a typical embodiment, the basic body has a substantially semicircular or semi-elliptical cross-section having a substantially flattened portion of the lateral area, wherein the at least one protrusion and/or the at least one recess is or are formed on the substantially flattened portion of the lateral area of the basic body.

In an embodiment, which may be combined with other embodiments disclosed herein, at least one portion of the lateral surface area of the anode rod has a roughness of about 10µm to about 4mm, the at least one portion being at least 30%, in particular at least 40%, of the lateral surface area of the anode rod.

In a typical embodiment, at least one contiguous portion of the lateral surface area is coated with a coating having a mean emissivity of more than 0.5, the at least one contiguous portion is at least 30% of the lateral surface area, in particular 50% of the lateral surface area.

For example, in an embodiment, which may be combined with other embodiments disclosed herein, the anode rod is manufactured of aluminium.

A further aspect concerns a sputtering system comprising at least one anode rod according an embodiment disclosed herein, and at least one sputtering cathode assembly comprising a backing plate for a planar target or a target backing tube for a rotatable cylindrical target.

In a typical embodiment, the sputtering system comprises a substrate support for supporting a substrate to be coated by sputtering, wherein the at least one portion having a roughness of 10µm to 4mm is disposed facing away from the substrate support.

For example in an embodiment, the sputtering system comprises a substrate support for supporting a substrate to be coated by sputtering, wherein the at least one flattened portion or the at least one contiguous portion is disposed facing away from the substrate support.

In a typical embodiment, which may be combined with other embodiments disclosed herein, the at least one rotatable cylindrical target assembly has a rotation axis, wherein the rotation axis of the cylindrical target assembly is substantially parallel to the longitudinal axis of the at least one anode rod.

In a further embodiment, two anode rods are disposed on radial opposed sides of the at least one cylindrical target assembly.

Further aspects, advantages and features of the present invention are apparent from the dependent claims, the description and the accompanying drawings.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 is a cross-sectional view of an embodiment of a sputtering system;
Fig. 2 shows a cross-section of an embodiment of an anode rod;
Fig. 3 shows a cross-section of a further embodiment of an anode rod;
Fig. 4 shows a cross-section of another embodiment of an anode rod;
Fig. 5 shows a cross-section of a further embodiment of an anode rod;
Fig. 6 shows a cross-section of a typical embodiment of an anode rod;
Fig. 7 shows a perspective view of another embodiment of an anode rod;
Fig. 8 is a cross-sectional view of a portion of a vacuum chamber of a sputtering system;
Fig. 9 is a schematical graph showing the correlation between the form of a groove an the emissivity.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

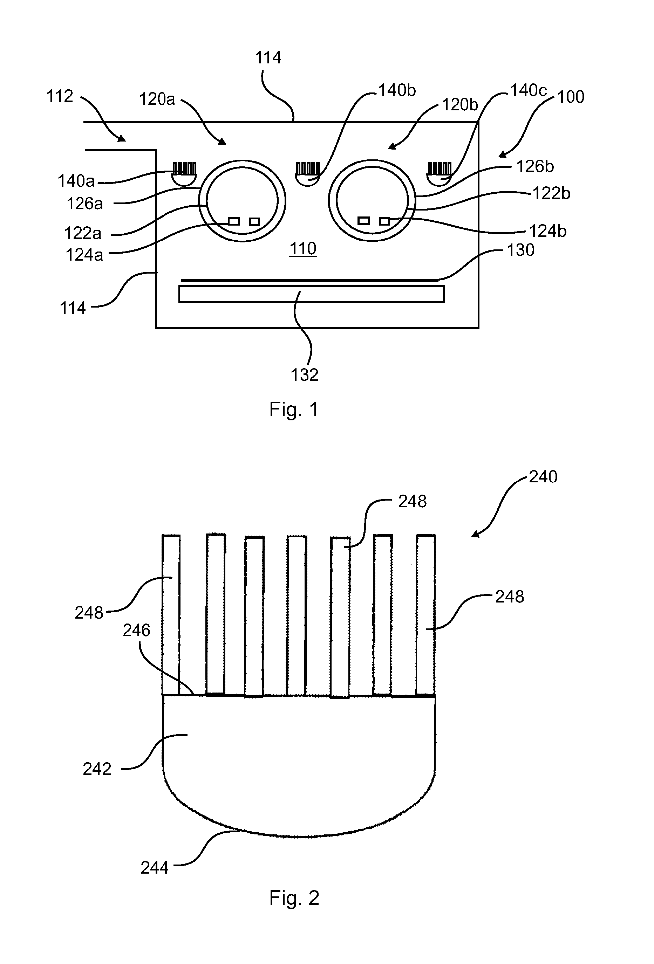

Referring to the drawings, where like or similar elements are designated with identical reference numbers throughout the different figures, Fig. 1 shows a schematic cross-section of a sputtering system 100 having a vacuum chamber 110. The vacuum chamber has an inlet port 112, which may be used to provide a sputtering gas into the vacuum chamber 110, and an outlet (pumping) port (not shown). The vacuum chamber is limited by vacuum chamber walls 114. In typical embodiment, the sputtering system 100 includes two rotating cylindrical target assemblies 120a, 120b. Each cylindrical target assembly 120a, 120b is rotating about a rotating axis corresponding to the longitudinal axis. In other embodiments, which may be combined with other embodiments disclosed herein, the sputtering system may include one, three, four or more cylindrical target assemblies. In a typical embodiment, which may be combined with other embodiments disclosed herein, the rotating cylindrical target assemblies 120a, 120b are driven by a drive assembly not shown in Fig. 1. The rotating cylindrical target assemblies 120a, 120b each include a backing tube 122a, 122b in which magnets 124a, 124b are disposed. Further, cylindrical target elements 126a, 126b are disposed around the backing tube 122a, 122b. For example, the cylindrical target elements 126a, 126b may not be bonded to the respective backing tube 122a, 122b. In Fig. 1 horizontal rotating cylindrical target assemblies are shown. In some embodiments, which may be combined with other embodiments disclosed herein, vertical cylindrical target assemblies may be used. In a typical embodiment, the sputtering system is a DC sputtering system.

Further, in the vacuum chamber 110, a substrate 130 is disposed below the cylindrical target assemblies 120a, 120b. The substrate 130 may be arranged, in a typical embodiment, which may be combined with other embodiments disclosed herein, on a substrate support 132. In operation, a plasma is formed inside the vacuum chamber 110 between the cylindrical target assembly and the substrate by exciting a sputtering gas, for example argon. In further embodiments, the vacuum chamber may include substrate drive systems for driving a substrate to be coated 130 in or out of the vacuum chamber 110. For that reason, the vacuum chamber may include a vacuum lock chamber disposed at a wall of the vacuum chamber 110.

Further, anode rods 140a, 140b and 140c are disposed parallel to and on both sides of the cylindrical target assemblies 120a, 120b. Thus, the longitudinal axis of the anode rods 140a, 140b, 140c is substantially parallel to the longitudinal or rotating axis of the cylindrical target assemblies 120a, 120b. Two adjacent cylindrical target assemblies 120a, 120b may have a common anode rod 140b. Thus, for example, a TFT cathode array includes N rotation cathodes, for example the cylindrical target assemblies, and N+1 anode rods. Thus, in Fig. 1 two cylindrical target assemblies and three anode rods 140a, 140b, 140c are shown. In a typical embodiment, the anode rods 140a, 140b, 140c are not actively cooled. Typically, during operation, the anode rods are used to gather charged particles, for example electrons, and to transport them out of the vacuum chamber 110.

The anode rods are made in an embodiment, which may be combined with other embodiments disclosed herein, of aluminum. Aluminum has a high electrical and thermal conductivity and a low weight. Typically, aluminum has also a moderate price.

In an embodiment, the target backing tubes 122a, 122b are cooled. For that purpose a cooling fluid, for example water, may be provided in the target backing tubes 122a, 122b. Further, in typical embodiments, which may be combined with other embodiments, vacuum chamber walls 114 are also cooled. The cooling of the vacuum chamber walls 114 may be performed by a fluid cooling system, for example a water cooling system.

According to the typical embodiment, which may be combined with other embodiments described herein, the pressure in the vacuum chamber may be 10⁻⁴ to 10⁻² mbar, typically about 10⁻³ mbar. Thus, there are substantially no particles between the surface of the anode rod facing the chamber walls 114 and the anode rod 140a, 140b, 140c itself. Hence, one mechanism for anode rods 140a, 140b, 140c to loose thermal energy is thermal radiation. Typically, the energy loss by thermal radiation is proportional to the emitting surface and the thermal emissivity. By now, typically anode rods have a circular cross section which results in the lowest surface area by any given cross section area or any given mass. Typically, according to an embodiment, which may be combined with the embodiments disclosed herein, the temperature of the anode rods may be reduced by increasing the surface and/or the emissivity by changing the geometrical form and/or the surface properties.

According to Stefan-Boltzmann-Law, the total energy radiated per unit surface area of a black body is proportional to the fourth power of the black body's temperature T (absolute temperature). In a case of a grey body, that is a body that does not emit the full amount of radiative flux, the grey body radiates only a portion of the radiative flux that is characterized by its emissivity ε. The Stefan-Boltzmann-Law describes the thermal radiation and thus the possibility of a body to lose thermal energy by radiation.

In Fig. 2 a first embodiment of an anode rod 240 is shown. The anode rod 240 may be arranged in the vacuum chamber 110 at the places of the anode rods 140a, 140b, 140c. The anode rod 240 includes a basic body 242 having a substantially semicircular form in a cross section. In other embodiments, the basic body 242 may have a rectangular or a semi-oval cross section. The anode rod has a first surface 244 adapted to face the substrate 130 to be coated. A second surface 246 of the basic body 242 is adapted to face the walls 114 of the vacuum chamber 110. Typically, the second surface 246 adapted to face the wall 114 is disposed opposite to the first surface 244 adapted to face the substrate 130 or the substrate support 132. On the second surface 246 of the basic body 142 adapted to face the walls 114 of the vacuum chamber, a plurality of protrusions 248 are disposed. In a typical embodiment, the protrusions 348 may be in a regular spaced apart configuration. The protrusions 248 may have in a typical embodiment, which may be combined with other embodiments disclosed herein, a rectangular cross section, wherein the small side is disposed on the basic body 242. In other embodiments, the protrusions 248 may have a triangular or trapezoidal cross section. Typically, the protrusions 248 may have a longitudinal extension from the second surface 246 in direction of the chamber wall 114 of about ½ to 1/1, in particular about 2/3, of the diameter, in particular in parallel to the substrate to be coated, of the basic body 242. The protrusions 248 may be formed, in a typical embodiment, in one piece with the basic body 242. Thus, in case of an anode rode 240 cast from aluminum, the anode rod may be easily extruded as a single piece. In the embodiment shown in Fig. 2, the lateral surface area of the anode rod 240 is approximately three times greater than the lateral surface of a circular cylinder having the same diameter. Thus, the emissivity of the anode rod 240 is also three times greater than the emissivity of the anode rod in form of a circular cylinder.

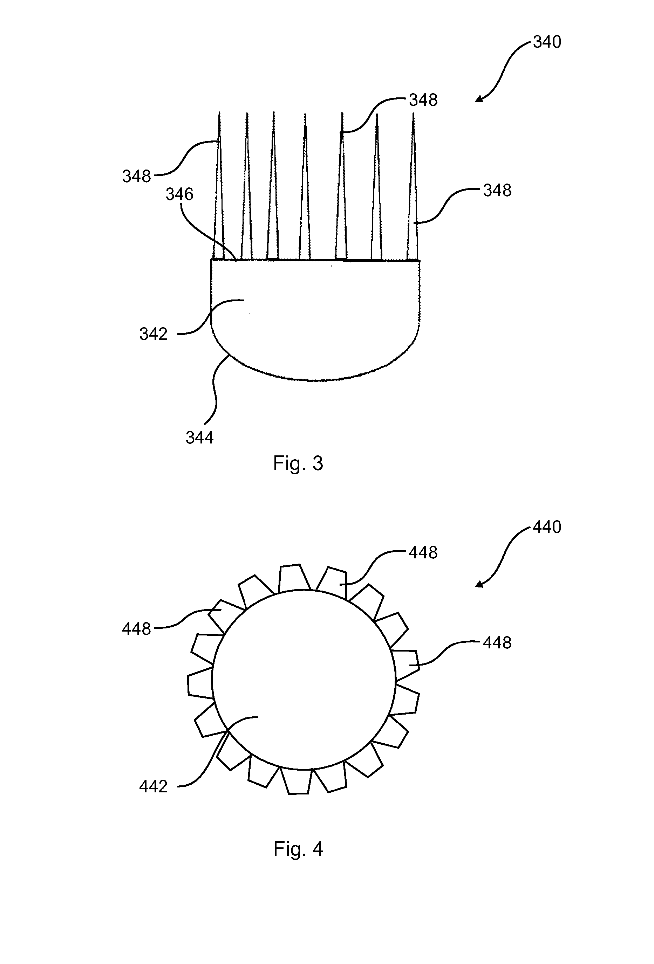

Fig. 3 shows a cross section of a further embodiment of an anode rod 340. The anode rod 340 includes a basic body 342 having a first surface 344 adapted to be directed to the substrate 130 or the substrate support 132 and a second surface 346 adapted to be directed to a wall 114 of the vacuum chamber 110. Typically the second surface 346 is opposite the first surface 344. The basic body 342 has a substantially semi-oval cross section wherein the second surface 346 is a flat surface. A plurality of protrusions 348, which have a substantially triangular cross section, are disposed on the second surface 346 of the basic body 342. Typically, the cross-section of the protrusions 348 is in a plane orthogonal to the longitudinal axis of the anode rod 340. In a typical embodiment, the protrusions 348 may be disposed in a regular spaced apart configuration. Typically, the protrusions 348 may have a longitudinal extension from the second surface 346 in direction of the chamber wall 114 of about ½ to 1/1, in particular about 2/3 to about 3/4, of the diameter, in particular in parallel to the substrate to be coated, of the basic body 242.

Fig. 4 shows a cross section of a further embodiment of an anode rod. The anode rod 440 has a circular basic body 442. In a further embodiment, which may be combined with other embodiments disclosed herein, the basic body may have an elliptical or oval cross section. On the lateral area of the basic body 442 a plurality of protrusions 448 is disposed. The protrusions may be provided integrally with the basic body 442 of the anode rod. The protrusions may have in an embodiment a substantially trapezoidal cross section. Typically, the cross-section of the protrusions is in a plane orthogonal to the longitudinal axis of the anode rod. In an embodiment, the protrusions 448 may be disposed continuously around the lateral area of the basic body. In another embodiment, the protrusions may be spaced apart from each other. In a further embodiment, the protrusions 448 may be disposed only at a portion of the lateral area of the basic body adapted to face the walls 114 of the vacuum chamber 110, wherein the portion of the lateral area of the basic body without the protrusions 448 is adapted to face the substrate 130. Typically, the protrusions may extend in radial direction from the basic body by about 5% to 50%, in particular 10% to 40%, of the diameter of the basic body 442 of the anode rod 440.

The protrusions of the embodiments shown in Fig. 2, Fig. 3 and Fig. 4 may be in a typical embodiment ribs which are extending in parallel from first end of the anode rod to a second end of the anode rod in a longitudinal direction of the anode rod. Thus, the protrusions or ribs may be easy to be produced, for example by extruding the anode rod. Thus, the ribs or protrusions are typically arranged in parallel to the longitudinal axis of the cylindrical target assemblies and the longitudinal axis of the anode rod.

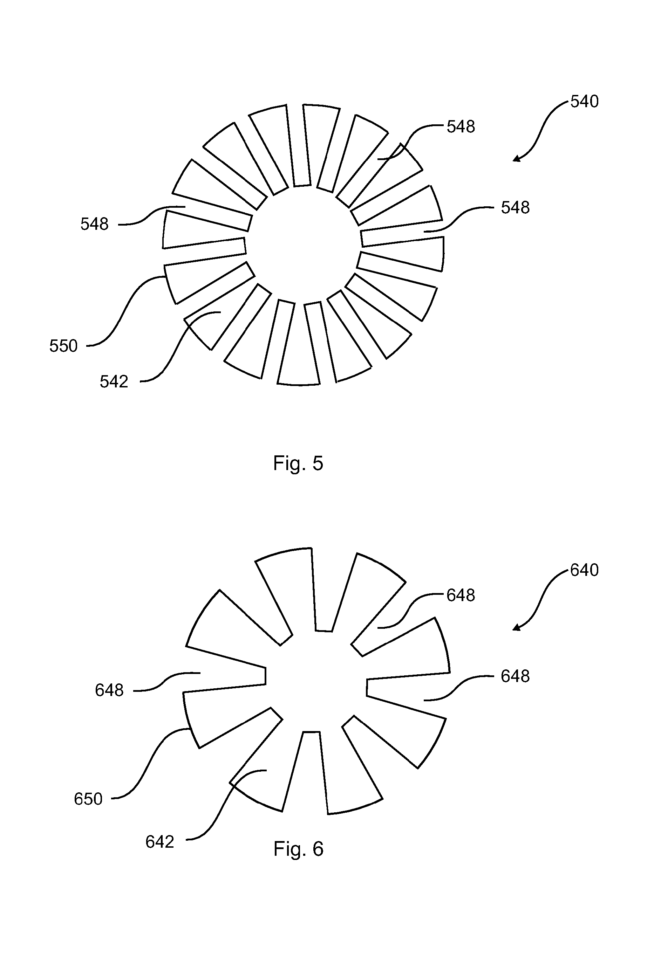

Fig. 5 shows a cross section of another embodiment of an anode rod 540. The anode rod has a basic body having a circular cross section. In a further embodiment, the cross section of the basic body 542 may be elliptical or an oval. A plurality of recesses 548 are formed in the basic body. The recesses 548 may have a depth with respect to the surface 550 of the basic body of substantially a third of the diameter of the basic body. In other embodiments the recesses 548 may have a depth in radial direction with respect to the surface 550 of the basic body of about 25% to 50%. In a typical embodiment, which may be combined with other embodiments disclosed herein, the recesses 548 have a substantially rectangular cross section. Typically, the cross-section of the recesses is in a plane orthogonal to the longitudinal axis of the anode rod. In other embodiments, the cross section of the recesses may be triangular or trapezoidal. The recesses 548 may be typically regularly spaced around the circumference of the basic body 542. In a typical embodiment, the recesses are only provided at a portion of the lateral area of the basic body adapted to face the walls 114 of the vacuum chamber 110. The recesses 548 may have a longitudinal extension in parallel to the longitudinal axis of the basic body. Typically, the recesses 548 may have the form of a groove.

Fig. 6 shows a further embodiment, which is similar to the embodiment shown in Fig. 5, of the anode rod, wherein the anode rod has a substantially circular cross section of the basic body. In the lateral area of the basic body recesses 648 are formed which have a substantially trapezoidal cross section. The recesses have a depth with respect to the surface or circumference 650 of the basic body 642 of about one circuit of the diameter of the substantially cross circular cross section of the basic body. In other embodiments the depth may be between ¼ and ⅜ of the diameter of the basic body 642. The recesses 648 are regularly spaced around the lateral area of the basic body. In a typical embodiment, the recesses 648 are formed as a groove extending in the longitudinal direction of the anode rod. Typically, the cross-section of the recesses is in a plane orthogonal to the longitudinal axis of the anode rod.

The rib and/or the grooves 248, 348, 448, 548, 648 of the anode rods 240, 340, 440, 540, 640 may have a longitudinal length of about 50 %, in particular at least 70 %, of the axial extension of the anode rod, in particular in parallel to the axial direction of the anode rod. In another embodiment, which may be combined with other embodiments disclosed herein, the rib and/or the grooves of the anode rods may have the same longitudinal extension as the axial extension of the anode rod. In a further embodiment, which may be combined with other embodiments disclosed herein, the at least one protrusion or at least one recess are or are disposed, typically regularly spaced apart, on a contiguous portion of the lateral area of the basic body. The contiguous portion is more than about 25 percent, in particular more than 40 percent, of the lateral area of the basic body. For example, in an embodiment, the contiguous portion is disposed facing away from the substrate support, in particular it is adapted to face the wall of the vacuum chamber. Even in some embodiments, protrusions and recesses may be combined.

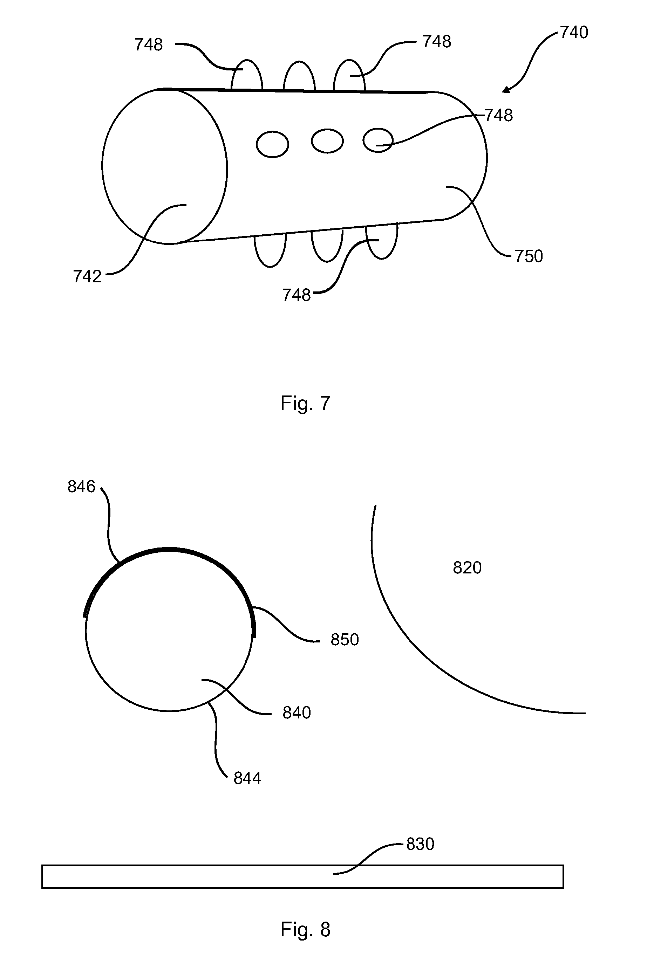

A further embodiment of an anode rod 740 is shown in Fig. 7. The anode rod has a circular cylindrical base body 740 having a lateral surface 750. On the lateral surface 750 a plurality of individual noses 748 are disposed.

In a further embodiment, the lateral surface area of the anode rod, in particular the surface of the anode rod adapted to face the wall 114 of the vacuum chamber 110 may be further treated, for example sandblasted. For example, a portion of the lateral surface area of an anode rod, for example a cylindrical anode rod having a circular cross-section, may have a roughness of about 10µm to about 4mm, in particular about 0,1mm to about 1mm. For example, the at least one portion is at least 30%, for example more than 50%, of the lateral surface area of the anode rod. Typically, the portion may be adapted to face the wall 114 of the vacuum chamber 110. For example, the portion may be disposed on the opposite side of the portion of the anode rod adapted to face the substrate to be coated. In a further embodiment, which may be combined with other embodiments disclosed herein, the protrusions or the recesses may be sandblasted and/or have a roughness of about 10µm to about 4mm, in particular about 0,1mm to about 1mm. In a typical embodiment, the roughness is an arithmetic average of the absolute values (Rₐ).

In another embodiment, shown in Fig. 8, which may be combined with other embodiments disclosed herein, the surface area of the anode rod, in particular the surface of the anode rod adapted to face the wall 114, may be coated, such that the emissivity is increased. Fig. 8 shows a cross-sectional view of a portion of a vacuum chamber. In the vacuum chamber a cylindrical target assembly 820 is arranged having a longitudinal axis substantially perpendicular to the paper plane. Further, the vacuum chamber includes a anode rod 840 having a first portion 844 of the lateral surface adapted to face a substrate 830 and a second portion 846 adapted to face a wall (not shown) of the vacuum chamber. Typically, the second portion 846 of the anode rod may be covered by a coating 850 increasing the emissivity. Typically, the electric properties may be retained even with a coating. Typically, at least one contiguous portion of the lateral surface area is coated with a coating having a mean emissivity of more than 0.5, in particular of more than 0,7, the at least one contiguous portion is at least 30%, in particular at least 50%, of the lateral surface area of the lateral surface area of the anode rod.

Even other simple geometric forms of the cross section would result in a larger relative surface with respect to a cylindrical anode rod having a circular cross-section. Another way to increase the surface area may be to bring grooves or ribs onto the anode rod. These elements would on one side increase its geometrical surface of the anode rod. On the other side the projected surface would not increase at the same factor. In this case the more structured surface would increase the emissivity and would therefore allow the anode rod to emit more thermal power at the same temperature. Typically, in an embodiment, where the ribs or groove or other structures are not symmetrically applied, the portion of the lateral area having a smooth surface may be coated and the structured surface area may be disposed in another portion which is not coated. In a typical embodiment, which may be combined with other embodiments disclosed herein, the grooves, recesses, protrusions and/or the ribs in a basic body according to an embodiment disclosed herein provide an emissivity which is 30%, in particular 50%, for example 100%, greater than the emissive power of a circular cylinder having the same volume and having an emissivity of ε=0,2. Even the portions of the anode rod facing other portions of the anode rod, for example in the grooves or of adjacent ribs, may contribute to an increased emissivity of the anode rod, as locally the emissivity of increased.

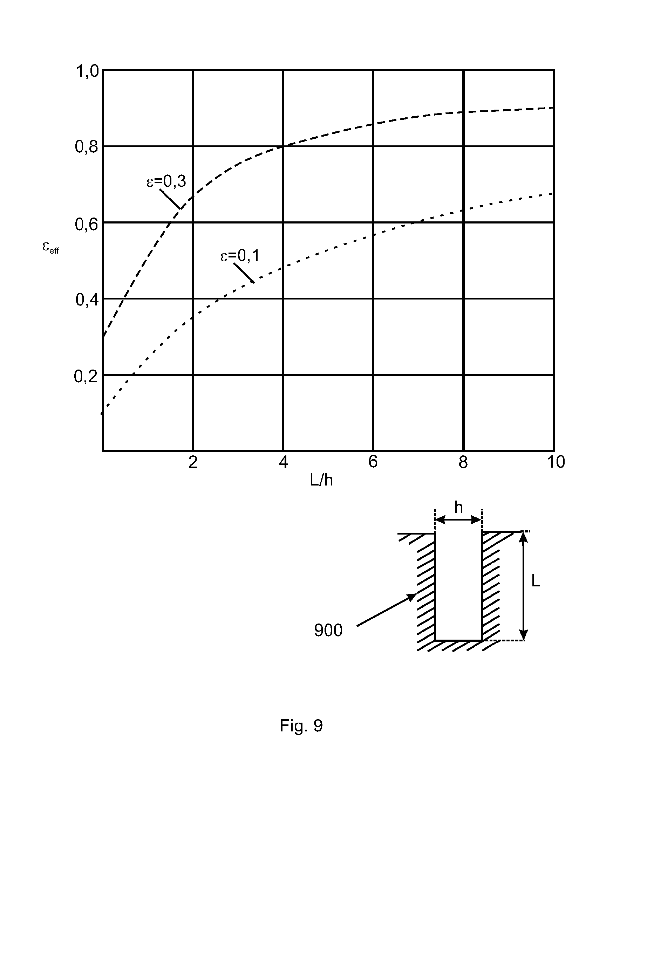

Fig. 9 shows the effective emissivity ε_{eff} of an opening of a rectangular groove 900 in dependence of the emissivity ε of the surface of the groove and the ratio of the depth L with respect to the width h of the groove 900. In a typical embodiment, the emissivity of a rectangular groove having the depth L and the width h orthogonal to the longitudinal extension of the groove, is raised due to the fact that the side surfaces of the groove face each other. For example a groove having a ratio L/h of about 2 increases the surface area, if only the surface of the groove is considered, by a factor 5. In this example, the two side surfaces exhibit the surface areas of twice 2•h, and the bottom area keeps its area h. This results in a total surface area of 5•h compared to the surface area of h the anode section without a groove. In such a case, if the material of the anode rod has an emissivity of 0,1 the emissivity of the surface area of groove, if only the surface of the groove is considered, is about 0,35. If the material of the anode rod has an emissivity of 0,3, the emissivity of the surface area of groove, if only the surface of the groove is considered, is about 0,68 (see Fig. 9).

In a further embodiment, which may be combined with other embodiments disclosed herein, a non-circular cross section of the basic body of the anode rod would likely result in an increased mechanical stability against bending due to thermal stress and/or coating by scattered material.

In a further embodiment, at least one anode rod according to an embodiment disclosed herein, may be used in a sputtering system comprising a planar cathode.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. An anode rod (140a, 140b, 140c, 240, 340, 440, 540, 640, 740, 840) for a sputtering system comprising a target (126a, 126b), a lateral surface area of the anode rod is at least 2 times greater than the lateral surface area of a circular cylinder having the same volume.

2. The anode rod according to claim 1, wherein
the lateral surface area of the anode rod is at least 6 times greater than the lateral surface area of the a circular cylinder having the same volume.

3. The anode rod according to claim 1 or 2, wherein
the emissive power of the anode rod is at least 1,5 times greater, in particular at least two times greater than the emissive power of a circular cylinder having the same volume and having an emissivity of ε=0,2.

4. The anode rod according to one of the preceding claims, wherein
the anode rod has a basic body (242, 342, 442, 542, 642), wherein the basic body has a lateral area and a cross section, the cross section is selected of the group consisting of:
a circle, of a semi-circle, of an oval, a semi-oval, a square, and a rectangle.

5. The anode rod according to claim 4, wherein the anode rod has at least one recess, in particular at least two, three, four, five or more recesses (548, 648), formed in a lateral area of the basic body, wherein the recesses are formed in particular as a groove and/or has at least one protrusion (248, 348, 448, 748), in particular at least two, three, four, five or more protrusions, formed on a lateral area of the basic body, wherein the protrusions are formed in particular as a rib and/or as a nose (748).

6. The anode rod according to claim 5, wherein the at least one groove and/or the at least one rib has or have a longitudinal length of at least 50%, in particular at least 70%, of the axial extension of the anode rod.

7. The anode rod according to one of the claims 5 to 6, wherein
the at least one rib and/or groove has or have a longitudinal extension parallel to the axial direction of the anode rod.

8. The anode rod according to one of the claims 5 to 7, wherein
the at least one rib and/or the at least one groove has or have a cross section selected from the group consisting of a substantial triangular cross-section, trapezoidal cross-section, rectangular cross-section, semi-circular cross-section, and any combinations thereof.

9. The anode rod according to one of the claims 5 to 8, wherein
the at least one protrusion and/or at least one recess is or are disposed, in particular regularly spaced apart, on a contiguous portion of the lateral area of the basic body, the contiguous portion is more than about 25 percent, in particular more than 40 percent, of the lateral area of the basic body.

10. The anode rod according to one of the claims 5 to 9, wherein
the basic body has a substantially semicircular or semi-elliptical cross-section having a substantially flattened portion (246, 346) of the lateral area, wherein the at least one protrusion and/or the at least one recess is or are formed on the substantially flattened portion of the lateral area of the basic body.

11. The anode rod according to one of the preceding claims, wherein
at least one portion of the lateral surface area of the anode rod has a roughness of about 10µm to about 4mm, the at least one portion being at least 30%, in particular at least 40%, of the lateral surface area of the anode rod.

12. The anode rod according to one of the preceding claims, wherein
at least one contiguous portion of the lateral surface area is coated with a coating having a mean emissivity of more than 0.5, the at least one contiguous portion is at least 30% of the lateral surface area, in particular 50% of the lateral surface area.

13. A sputtering system (100) comprising at least one anode rod according to one of the preceding claims and at least one sputtering cathode assembly (120a, 120b, 820) comprising a backing plate for a planar target or a target backing tube (122a, 122b) for a rotatable cylindrical target.

14. The sputtering system according to claim 13, wherein the sputtering system comprises a substrate support (132) for supporting a substrate to be coated by sputtering, wherein the at least one portion having a roughness of 10µm to 4mm is disposed facing away from the substrate support.

15. The sputtering system according to claim 13 or 14, wherein the sputtering system comprises a substrate support for supporting a substrate to be coated by sputtering, wherein the at least one flattened portion (246, 346) or the at least one contiguous portion is disposed facing away from the substrate support.
